# EUROPEAN PATENT APPLICATION

(11) **EP 4 095 892 A1**
(43) Date of publication of application: **30.11.2022**
(21) Application number: 22175631.5
(22) Date of filing: 26.05.2022
(51) Int. Cl.: H01L 21/768, H01L 23/532, H01L 21/66

(54) **METHOD OF MANUFACTURING A REDISTRIBUTION LAYER, REDISTRIBUTION LAYER, INTEGRATED CIRCUIT**

(30) Priority: 28.05.2021 IT 202100014060
(71) Applicant: STMicroelectronics S.r.l., 20864 Agrate Brianza (MB) (IT)
(72) Inventor: SCIARRILLO, Samuele, 20865 USMATE VELATE (MB) (IT); COLPANI, Paolo, 20864 AGRATE BRIANZA (MB) (IT)
(74) Representative: Studio Torta S.p.A.

(57) **Abstract**

A method of manufacturing a redistribution layer (32) for an integrated circuit (30), comprising the steps of: forming a conductive interconnection layer (33); forming a conductive body (40; 40, 38; 41) in electrical contract with said interconnection layer (33); and covering the conductive body with a first coating layer (42) having a thickness lower than 100 nm and configured to provide a protection against oxidation and/or corrosion of said conductive body (40; 40, 38). To carry out an electrical test of the integrated circuit, a testing probe locally perforates the first coating layer (42) until the conductive body (40) is electrically contacted by said testing probe.

## Description

The present invention relates to a method of manufacturing a redistribution layer, a redistribution layer, an integrated circuit including the redistribution layer.

As is known, integrated circuits (ICs) are composed of several overlapping layers made of semiconducting, insulating and conductive materials, typically defined by photolithography.

In a first phase (front end of line, FEOL) of a manufacturing process of an integrated circuit, individual devices such as, among others, transistors, diodes, resistors and capacitors, are patterned on the surface of a wafer.

In a second phase (back end of line, BEOL), the individual devices are interconnected by conductive metal lines. In particular, due to the complexity of modern IC layouts and high density of individual devices, the back end of line process comprises manufacturing several stacked metal layers, electrically insulated from one another by dielectric layers; vias through the dielectric layers allow connecting any metal layer to the metal layers below and/or the one above.

In a third phase of the IC manufacturing process, belonging to the BEOL phase of package process, a redistribution layer (RDL) is patterned above the last metal interconnection layer. As is known, the redistribution layer is an extra metal layer used for routing the input/output pads to other locations on the die area, enabling simpler chip-to-chip bonding. Moreover it is a power metal layer able to reduce the I/O access resistance. As last metal layer is also designed to fit the packaging process requirements.

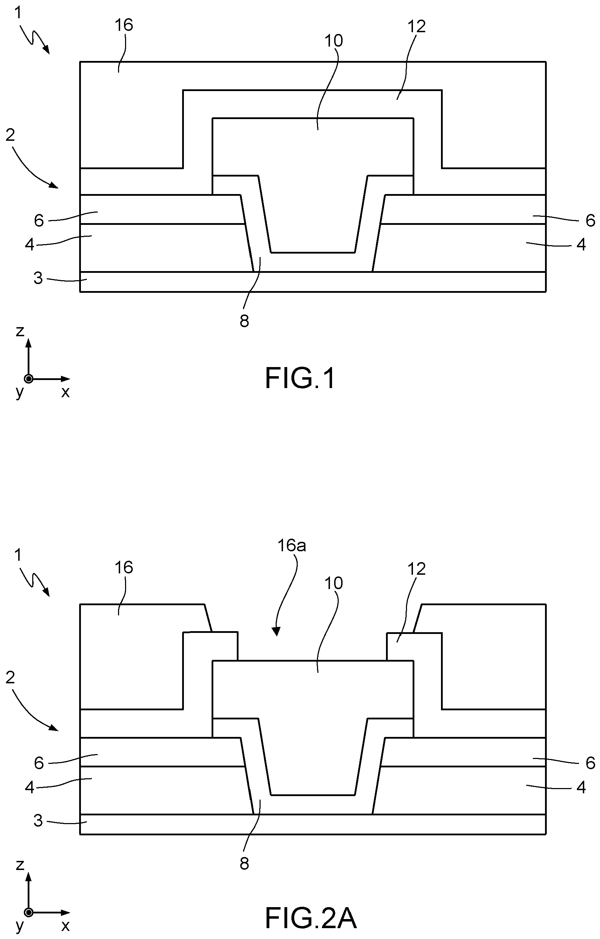

Figure 1 shows schematically a cross-section view of a portion of an IC 1 including a pad, which is not explicitly depicted and is the region of IC 1 to be accessed through wire bonding or other contact solutions during the packaging process, and a redistribution layer (RDL) 2 that can be used to provide or acquire electrical signals to/from the pad, as known in the art. In particular, the IC 1 is represented in a system of spatial coordinates defined by three axes x, y, z, orthogonal to one another and the cross-section view is taken on an xz plane, defined by the x axis and the z axis. In the following, thicknesses, depths and heights are intended as measured along the z axis, and the meanings of "top" and "bottom", "above" and "below" are defined with reference to the direction of the z axis.

The IC 1 includes an interconnection layer 3, made of conductive material; the redistribution layer 2 includes a dielectric layer 4 extending above the interconnection layer 3 and a first passivation layer 6 extending above the dielectric layer 4. One or more further layers (not shown) may be present between the interconnection layer 3 and the dielectric layer 4 (e.g., in case layer 3 is of Cu, a further SiN layer that protect the Cu metallization may be present between the interconnection layer 3 and the dielectric layer 4) .

The redistribution layer 2 further comprises a barrier region 8, extending above a top surface of the first passivation layer 6 and across the whole depth of the first passivation layer 6 and of the dielectric layer 4, so as to be in contact with the interconnection layer 3.

The redistribution layer 2 further comprises a conductive region 10, extending on top of the barrier region 8. In particular, in a top view of the IC 1, the conductive region 10 is extending only inside the area defined by the barrier region 8.

The barrier region 8 and the conductive region 10 form a conductive path from the interconnection layer 3 to the top surface of the first passivation layer 6.

The redistribution layer 2 further comprises a coating region 12, extending above the first passivation layer 6, around the conductive region 10 and the barrier region 8, and above the conductive region 10. The coating region 12 is in contact with the top surface of the first passivation layer 6, the conductive region 10 and the barrier region 8. Far from the pad (that is the representation of Figure 1), the coating region 12 fully covers the conductive region 10.

In other words, the coating region 12 completely covers the portions of the barrier region 8 and of the conductive region 10 extending above the top surface 6a of the first passivation layer 6.

The redistribution layer 2 further comprises a second passivation layer, or photosensitive insulation layer, 16 (e.g. polyimide, PBO, Epoxy, etc.), fully covering the coating region 12 far from the pad.

In particular, a convenient choice of conductive materials for the redistribution layer 2 is such that the conductive region 10 is made of copper (Cu), the coating region 12 is made of Silicon Nitride with a thickness of about 0.5-1 µm. Other thicknesses may be chosen, according to the needs.

At the pad location, the conductive region 10 can be electrically contacted by wire bonding or, alternatively, by a conductive pillar (e.g., of copper) grown on the conductive region 10 (e.g., by electroplating) through an opening formed through the second passivation layer 16 and the coating layer 12, as shown in Figure 2A.

With reference to Figure 2A, features common to those of Figure 1 are identified with same reference numerals. Here, the conductive region 10 is covered by the coating layer 12 of Silicon Nitride and by the passivation layer 16. The passivation layer 16 extends laterally to, and partially above, the conductive region 10 and the coating layer 12. In particular, the passivation layer 16 has a top opening 16a aimed at allowing access to the conductive region 10. The conductive region 10 can be electrically and physically accessed through such opening 16a after a step of etching away the portion of the coating layer 12 exposed through the opening 16a.

After removal of such portion of the coating layer 12, the conductive region 10 is electrically accessible to carry out electrical testing, in particular EWS ("Electrical Wafer Sorting") testing, functional testing, or other reliability tests. In order not to damage, or cause corrosion / oxidation of, the exposed part of the conductive region 10, the EWS test should be conducted at low temperatures (usually, ambient temperature or lower). This limits the number and typology of tests that can be carried out. Moreover, notwithstanding all care taken during these steps, the copper surface still undergoes oxidations / corrosion phenomena before, during and/or after EWS tests, which generates a general degradation of the surface of the conductive region 10.

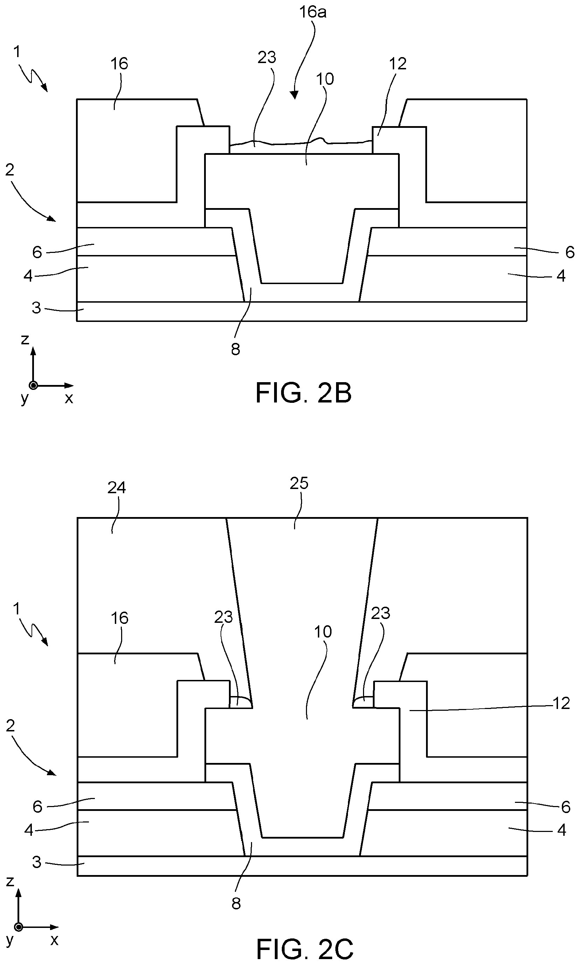

As shown in Figure 2B, an undesired layer 23 (e.g., oxidized or corroded layer) is shown extending not only on the exposed copper surface, but also partially under the coating layer 12 (not shown in the figure).

Figure 2C shows further manufacturing steps to package the IC 1, where a molding layer 24 is deposited within the opening 16a on the conductive region 10 (and at least partially on the undesired layer 23). The molding layer 24 is opened at the conductive region 10 (e.g, through a LASER drilling process) to reach the conductive region 10. The undesired layer 23 and optionally the conductive region 10 are also partially removed through the LASER drilling process, to expose the underlying copper surface on which an electroplating copper growth process can be carried out, to grow the tick copper pillar 25 that provides electrical access to the redistribution layer 2.

During the manufacturing, the steps between the front-end process (Figure 2A) and the back-end process (Figure 2C) involve several corrosion issues of the Cu material, which is not passivated. Such corrosion phenomena may also negatively evolve later during the working life of the device.

As shown in Figure 2C, the not-removed portions of the molding layer 24 are coupled at least in part on a residual portion of the undesired layer 23. The presence of the undesired layer 23 under the protection layer 20 and /or under the molding layer 24 may cause an irreversible detachment of the protection layer 20 / molding layer 24 from the conductive region 10 during further manufacturing steps or, more dangerously, during the working life of the device thus manufactured. In fact, layer 23 is not of a stable material and can be prone to environmental contamination, such as Cl, SO₄ or Fluorine compounds, able to generate further corrosion of the RDL metallization.

The aim of the present invention is to provide a method of manufacturing a redistribution layer, a redistribution layer, and an integrated circuit including the redistribution layer, to overcome the problems previously illustrated.

According to the present invention, a method of manufacturing a redistribution layer, a redistribution layer, and an integrated circuit including the redistribution layer are provided, as defined in the annexed claims.

For a better understanding of the present invention, preferred embodiments thereof are now described, purely by way of non-limiting example and with reference to the attached drawings, wherein:
- Figure 1 is a cross-section view of a portion of an integrated circuit including a redistribution layer, according to the known art;
- Figures 2A-2C show manufacturing steps of the redistribution layer of Figure 1, according to the known art;
- Figure 3 is a cross-section view of a portion of an integrated circuit including a redistribution layer, according to an embodiment of the present invention;
- Figures 4A-4I are cross-section views of steps for manufacturing the redistribution layer of Figure 3;
- Figure 5 is a cross-section view of a portion of an integrated circuit including a redistribution layer, according to a further embodiment of the present invention; and
- Figures 6A and 6B show respective process steps for manufacturing the integrated circuit of Figure 5.

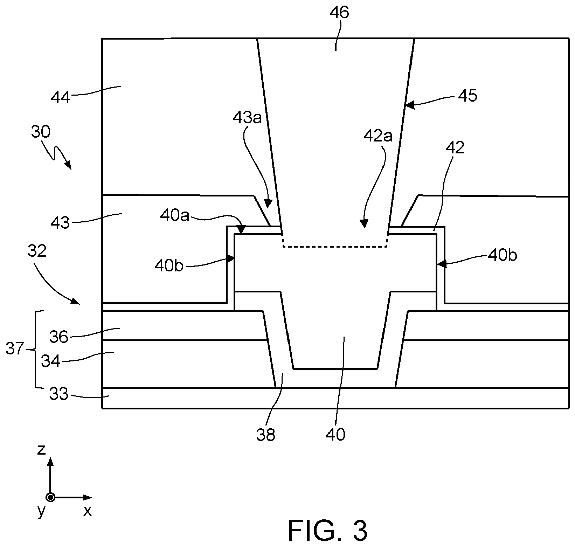

Figure 3 shows an integrated circuit, IC, 30 (only a portion of which is shown in the drawings), represented in a system of spatial coordinates defined by three axes x, y, z, orthogonal to one another and the cross-section view is taken on an xz plane, defined by the x axis and the z axis (analogously to Figure 1 and Figures 2A-2C). In the following, thicknesses, depths and heights are intended as measured along the z axis, and the meanings of "top" and "bottom", "above" and "below" are defined with reference to the direction of the z axis (i.e., such terms refer to respective views on the xy plane or a plane parallel to the xy plane).

Figure 3 shows schematically a cross-section view of a portion of a die housing the IC 30 comprising a redistribution layer (RDL) 32.

As already discussed, the redistribution layer 32 includes one or more extra metal layer(s) used for routing the input/output pads to other locations on the IC 30 (or on the die housing the IC 30), enabling simpler chip-to-chip bonding. As last metal layer, the RDL 32 can be designed to fit the packaging process requirements.

The redistribution layer 32 can be used to provide electrical signals to the IC 30 and/or to acquire electrical signals from the IC 30.

In one embodiment, the die of Figure 3 is a completely processed ("completed") silicon die, with a insulating / molding material(s) on its top surface. Conductive strips or regions that form the RDL 32, as better discussed later, are covered by the insulating / molding layer(s). In this context, a "completed" semiconductor die or a "completed" integrated circuit is one that has all of its circuits fully interconnected and only needs external connection(s) to be operational. The external connection is provided, as apparent from the description below, by the elements identified with reference numerals 41 and 46.

The IC 30 further comprises an interconnection layer 33, made of conductive material such as aluminium or copper. In particular, the interconnection layer 33 is the last metal line of the IC 30 (in the BEOL).

The redistribution layer 32 includes a dielectric layer 34 extending above the interconnection layer 33 and a passivation layer 36 extending above the dielectric layer 34. One or more further layers (not shown) may optionally be present between the interconnection layer 33 and the dielectric layer 34 (e.g., in case layer 33 is of Cu, a further SiN layer that protect the Cu metallization may be present between the interconnection layer 33 and the dielectric layer 34). In particular, the dielectric layer 34 is made of an insulating material, such as silicon dioxide (SiO₂) or a multi stack dielectric made by SiN and SiO₂; the passivation layer 36 is made of an insulating material, such as silicon nitride (Si₃N₄).

The dielectric layer 34 and the passivation layer 36 may be replaced by one single layer (not shown). Therefore, in the following, the term "insulating layer 37" refers either to the stack composed of the dielectric layer 34 and the passivation layer 36, or to a stack formed by more than two layers (e.g., three layers), or otherwise a single layer.

The redistribution layer 32 further comprises a barrier region 38 of conductive material. The barrier region 38 extends across the whole thickness of the insulating layer 37, so as to be in contact with the interconnection layer 33.

The redistribution layer 32 further comprises a conductive region 40, extending on top of the barrier region 38, and having a top surface 40a and lateral walls (or sidewalls) 40b. In particular, in a top view of the IC 30, not shown in the figures, the conductive region 40 is extending only inside the area defined by the barrier region 38. In the following, the term "conductive body" refers to a stack 41 including the barrier region 38 and the conductive region 40. It is noted that, according to a further embodiment, the barrier region 38 may be omitted; accordingly, in such embodiment, the term "conductive body" refers to the conductive region 40 only.

The conductive body 41 forms a conductive path from the interconnection layer 33 to the top surface of the insulating layer 37, to form a proper contact region for supplying and/or acquiring electrical signals to/from the interconnection layer 33. The conductive body 41 may extend in part on the insulating layer 37.

In one embodiment, the barrier region 38 is made of conductive material, such as titanium (Ti), or titanium-tungsten (TiW), or titanium nitride (TiN), and has thickness comprised for instance between 270 nm and 330 nm. In one embodiment, the conductive region 40 is made of conductive material, in particular metal such as copper (Cu), and has thickness comprised for instance between 8 µm and 12 µm.

The redistribution layer 32 further comprises a coating region 42 that partially covers the conductive region 40; in particular, the coating region 42 extends around the conductive region 40 completely covering the lateral walls of the conductive region 40 and partially above the conductive region 40, leaving an opening 42a at the top surface of the conductive region 40, through which the surface 40a of the conductive region 40 is exposed during intermediate manufacturing steps (as better detailed later).

According to an aspect of the present invention, the coating region 42 is of a material that provides a protection of the conductive region 40 against oxidation and /or corrosion phenomena, and has a thickness in the nanometers range (i.e., lower than 100 nm). For instance, the thickness of the coating region 42 is uniform and is between 1 nm and 100 nm, more in particular between 5 nm and 50 nm.

According to the present invention, the coating layer 42 is of an insulating or dielectric material, in particular including Aluminium or Hafnium, or is of an alloy or composite material including Aluminium and/or Hafnium. Exemplary materials are Al₂O₃, HfO₂, HfᵢAlⱼOₖ (where i, j and k are freely selectable), AlN, AlᵢNⱼOₖ (where i, j and k are freely selectable), HfNᵢ (where i is freely selectable). The coating layer 42 may also be a stack formed by a plurality of layers including Aluminum and /or Hafnium and/or their alloys or composites, such as a stack including two or more among HfO₂/Al₂O₃/AlN/HfNᵢ.

Other materials or alloys are possible, provided that they can act as protecting layers against corrosion or degradation or oxidation phenomena of the conductive region 40, and can be deposited with a thickness within the above-identified range.

The coating layer 42 has the following characteristics: good conformity, good continuity, good chemical resistance, good mechanical-electrical properties, and it is not electrically conductive (i.e., it has dielectric or insulating properties). In particular, the conformity and the continuity directly derive from the choice, better discussed later, of depositing this layer by atomic layer deposition (ALD); the chemical resistance, electrical properties and the mechanical-electrical properties are a consequence of the material chosen (as discussed above).

A further insulating layer 43, such as a photosensitive insulating layer, extends above the insulating layer 37, around the coating region 42 and partially above the coating region 42 (i.e., partially above the portions of the coating region 42 which extends above the conductive region 40). The insulating layer 43 has an opening 43a that is larger than the opening 42a; the opening 42a is moreover completely contained (in top-plan view, on the xy plane) within the opening 43a, so that the surface of the conductive region 40 is exposed through both openings 42a and 43a during intermediate manufacturing steps (as better detailed later). Materials of such further insulating layer 43 include polyimide, PBO, Epoxy, photosensitive organic material, etc.

A molding layer 44 extends above the insulating layer 43, and the coating layer 42. The molding layer 44 has a passing hole 45 aligned with the openings 42a and 43a or larger than openings 42a, 43a, so that the conductive region 40 is exposed through the openings 42a, 43a and the passing hole 45 during intermediate manufacturing steps (as better detailed later).

A tick copper layer 46 extends within the passing hole 45 and the openings 43a and 42a, reaching the top surface 40a of the conductive region 40 and thus providing electrical access to the conductive region 40 and to the interconnection layer 33 from the environment external to the redistribution layer 42.

It is noted that the molding layer 44 is physically coupled to (lies on) both the insulating layer 43 and the coating layer 42. Since the coating layer 42 adheres to the conductive region 40 without intermediate undesired layers or regions, and the molding layer 44 adheres to the coating layer 42 without intermediate undesired layers or regions, delamination or detachments issues are not present. It is noted that, in other embodiments of the present invention, not shown in the drawings, further layers or regions may be present at the interface between the coating layer 42 and the conductive region 40 and/ at the interface between the molding layer 44 and the coating layer 42, with the aim of improving the adherence, or for other manufacturing or electrical requirements. In any case, it is noted that according to all the embodiments of the present invention, a corroded or oxidized layer like the undesired layer 23 in Figure 2B is not present.

EWS ("Electrical Wafer Sorting") testing is normally carried out before the formation of the thick copper layer 46 (and normally before formation of the molding layer 44). In particular, according to an aspect of the present invention, EWS testing is carried out at a manufacturing step when the conductive layer 40 is completely covered with, and therefore protected by, the coating layer 42.

As known, EWS testing is carried out using a contacting probe or tip of hard material, typically metal, that is configured to directly contact a conductive surface. Here, during EWS testing, the contacting probe/tip contacts the conductive layer 40. The presence of the coating layer 42 does not significantly impact the execution of EWS tests, since it is thin enough for the contacting probe/tip to "break" it or, more specifically, to pass through it without difficulties. Therefore, during EWS testing, the contacting probe/tip is directed on the coating layer 42 at the conductive layer 40 and pressed on the coating layer 42 until the contacting probe/tip penetrates through the coating layer 42 and reaches the conductive layer 40, establishing the required electrical contact for carrying out the tests. The hole thus formed through the coating layer 42 almost exactly matches the dimensions and shape of the contacting probe/tip, and therefore the surface of the conductive layer 40 is protected against corrosion or oxidations phenomena that may happen during testing. High temperature testing (up and above 150°C, for example up to 200-300°C) can be carried out without damaging or causing the formation of undesired layers on the conductive layer 40. Other reliability tests, other the EWS testing or further to EWS testing, may also be carried out at high temperatures (up to 300°C).

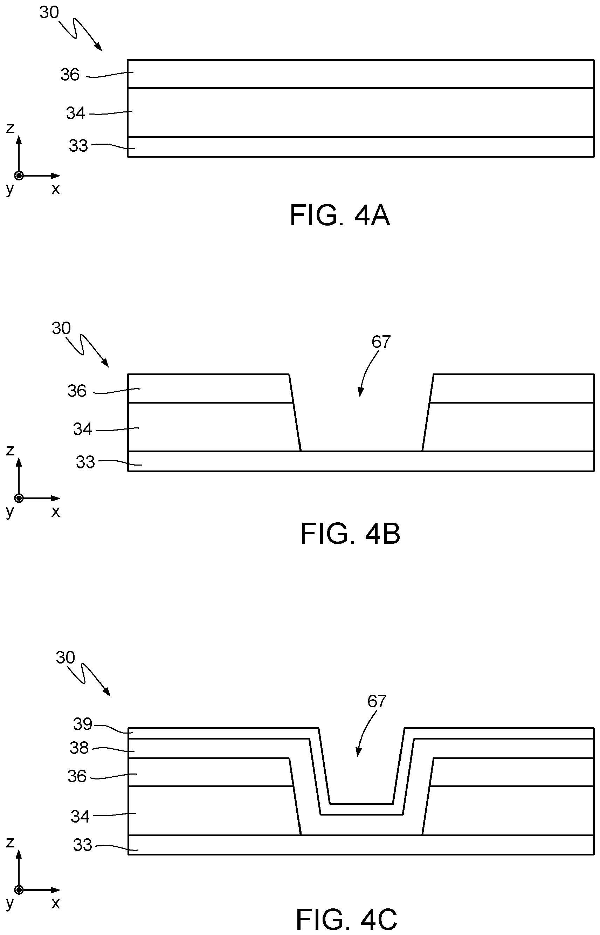

Figures 4A-4I show schematically a cross-section view of steps of a method of manufacturing a redistribution layer according to an embodiment of the present invention; in particular, the method of figures 4A-4I is a method of manufacturing the redistribution layer 22 of Figure 3. The redistribution layer is represented in the system of spatial coordinates defined by three axes x, y, z, orthogonal to one another and the cross-section view is taken on an xz plane, defined by the x axis and the z axis.

With reference to figure 4A, there is provided a wafer 60, including the interconnection layer 33. In particular, the interconnection layer 33 is the outermost metallization layer of the back end of line of an integrated circuit. The lower layers of the integrated circuit are not shown in figures 4A-4I.

The dielectric layer 34 is formed above the interconnection layer 33. In particular, the dielectric layer 34 is made of an insulating material, such as silicon dioxide (SiO₂), and has thickness comprised for instance between 900 nm and 1200 nm.

The passivation layer 36 is formed above the dielectric layer 34. In particular, the passivation layer 36 is made of an insulating material, such as silicon nitride (Si₃N₄), and has thickness comprised for instance between 500 nm and 650 nm. In the following, the term "insulating layer" refers, as already said, to the stack 37 formed by the dielectric layer 34 and the first passivation layer 36, or to a stack formed by more than two dielectric/insulating layers, or even to a single layer of insulating or dielectric or passivation material.

Then, figure 4B, a trench 67 is formed through the passivation layer 36 and the dielectric layer 34, up to exposing a surface of the interconnection layer 33. For instance, the trench 67 is formed by photolithography and dry etching steps of a known type, applied at the exposed surface of the first passivation layer 36.

Then, figure 4C, the barrier layer 38 is formed above the first passivation layer 36, for instance by physical vapor deposition (PVD). The barrier layer 38 partially fills the trench 67, covering the previously exposed sidewalls of the dielectric layer 34 and the first passivation layer 36 and the previously exposed surface of the interconnection layer 33.

In particular, the barrier layer 38 is made of conductive material, such as titanium (Ti), or titanium-tungsten (TiW), or titanium nitride (TiN). Moreover, the thickness of the barrier layer 38 may be lower than the combined thickness of the dielectric layer 34 and the first passivation layer 36, and in particular is comprised for instance between 270 nm and 330 nm. Then, a seed layer 39 is formed above the barrier layer 38, partially filling the trench 67. For instance, the seed layer 39 is deposited by PVD.

In particular, the seed layer 39 is made of conductive material, such as copper (Cu), and has thickness comprised for instance between 180 nm and 220 nm, such that the trench 67 is only partially filled by the seed layer 69.

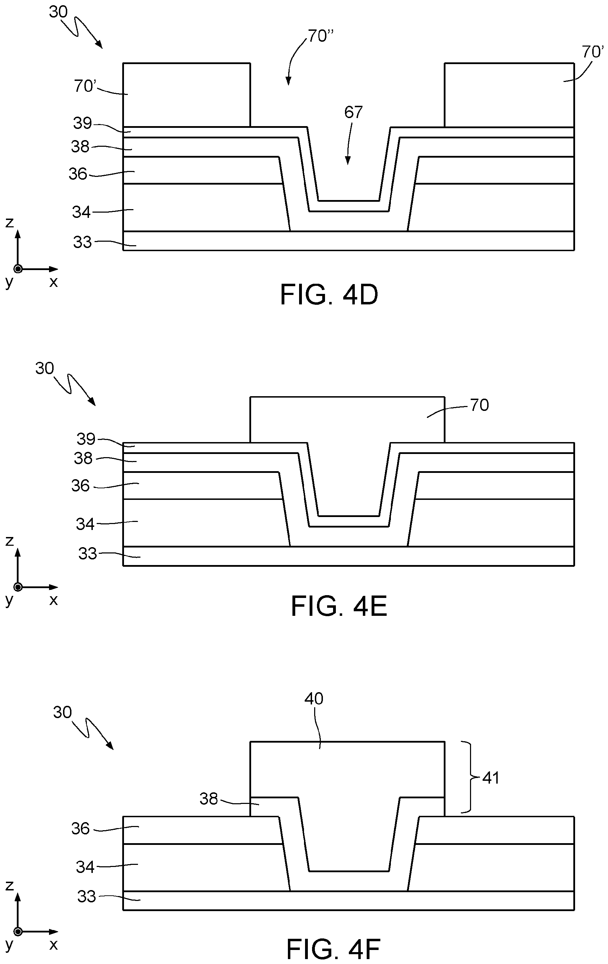

Then, figure 4D, a photolithography mask 70' is applied at the exposed surface of the seed layer 39. In particular, the layout of the photolithography mask 70' is designed considering that openings in the mask define areas in which a layer will be formed in a following step of the manufacturing method.

In particular, figure 4D shows an opening 70" of the photolithography mask 70', the opening 70" being centred on the partially filled trench 67 so that the trench 67 is not covered by the photolithography mask 70'.

Then, figure 4E, a conductive layer 70 is formed above the portions of the seed layer 39 not covered by the photolithography mask 70'. The thickness of the conductive layer 70 is high enough to completely fill the trench 67 and partially fill the opening 70" of the photolithography mask 70'.

In particular, the conductive layer 70 is made of the same conductive material of the seed layer 39, such as copper (Cu), and has thickness comprised for instance between 8 µm and 12 µm.

In particular, the conductive layer 70 is formed by electrodeposition. Then, the photolithography mask 70' is removed by a wet removal process, exposing portions of the seed layer 69 not covered by the conductive layer 70.

Then, figure 4F, said exposed portions of the seed layer 39, not covered by the conductive layer 70, are removed, for instance by wet etching, up to exposing the portions of the barrier layer 68 underneath them. Thus, the remaining portions of the seed layer 39, covered by the conductive layer 70, form, together with the conductive layer 70, the conductive region 40 of the redistribution layer 32 of Figure 3.

Then, the exposed portions of the barrier layer 68 are removed, for instance by wet etching, up to exposing the portions of the first passivation layer 36 underneath, without affecting the portions of the barrier layer 38 below the conductive layer 70, for instance by employing standard photolithography techniques by or directly using layer 40 as a mask for the underlying layer 38. As a consequence, the barrier region 38 of the redistribution layer 32 of Figure 3 is formed.

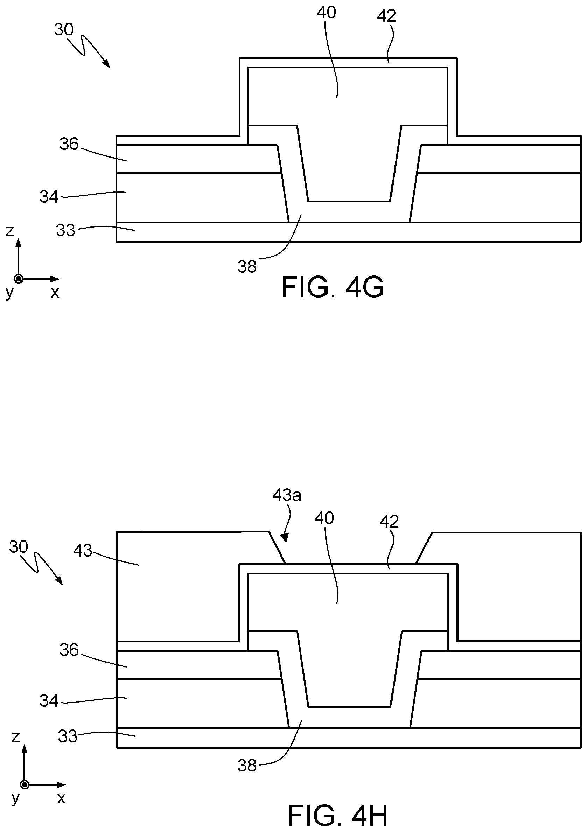

Then, Figure 4G, the coating layer 42 is formed on the exposed surface (top surface and sidewalls 40a, 40b) of the conductive layer 40 and on the side portions of the barrier region 38 exposed below the sidewalls of the conductive layer 40. The coating layer 42 is formed (deposited) by atomic layer deposition (ALD) of an alloy or compound including Aluminium or Hafnium, as already discussed.

The coating layer 42 completely and uniformly covers the conductive region 40 (as well as the passivation layer 36 which extends laterally to the conductive region 40).

Plasma-assisted ALD or thermal ALD can be used interchangeably to form the coating layer 42.

The process for forming the coating layer 42 includes the following parameters:
Temperature range during deposition, for plasma-assisted ALD: 20-300 °C;
Temperature range during deposition, for thermal ALD: 150 - 500 °C;
Type of precursors used (at least one among): TMA, H₂O, HfCl₄, O₃ + TEMAHf, N₂H₄, NH₃; typically, two precursors are used together, such as H₂O + TMA to obtain Al₂O₃, or HfCl₄ + H₂O to obtain HfO₂;
Pressure range during deposition, for plasma-assisted ALD: equal to or less than 1 Torr;
Pressure range during deposition, for thermal ALD: from 1 mTorr to 20 Torr.

The coating layer 42 thus formed has the following properties:
Density (@ 20 °C) in the range 2 - 11 g/cm³
Refractive index (at 550 nm - 633 nm wavelength) in the range 1.6 - 2.3.

Another process for forming the coating layer 42 (which can be applied in the context of the embodiment of Figure 3) includes carry out a PECVD deposition of a thin layer (i.e., under 100 nm, for example between 10 nm and 100 nm) of a dielectric or insulating material, such as a Silicon Nitride (e.g., Si₃N₄), or a silicon carbon nitride (SiCN).

Then, figure 4H, steps for forming the further insulating layer 43 are carried out. For example, the insulating layer 43 is formed by passivation with an organic photosensitive material deposited by spin coating or lamination (as examples), followed by a photolithographic process.

The aperture 43a is formed through the insulating layer 43, by patterning the insulating layer 43 through photolithographic techniques, to form an access to the coating layer 42. The etching of the insulating layer 43 stops at the interface with the coating layer 42. According to an aspect of the present invention, the insulating layer 43 and the coating layer 42 are of respective materials that can be selectively etched.

After the steps of Figure 4G or of Figure 4H, the EWS test, or any other electrical test, can be carried out, as already described, since the coating layer 42 is directly accessible by the testing probe.

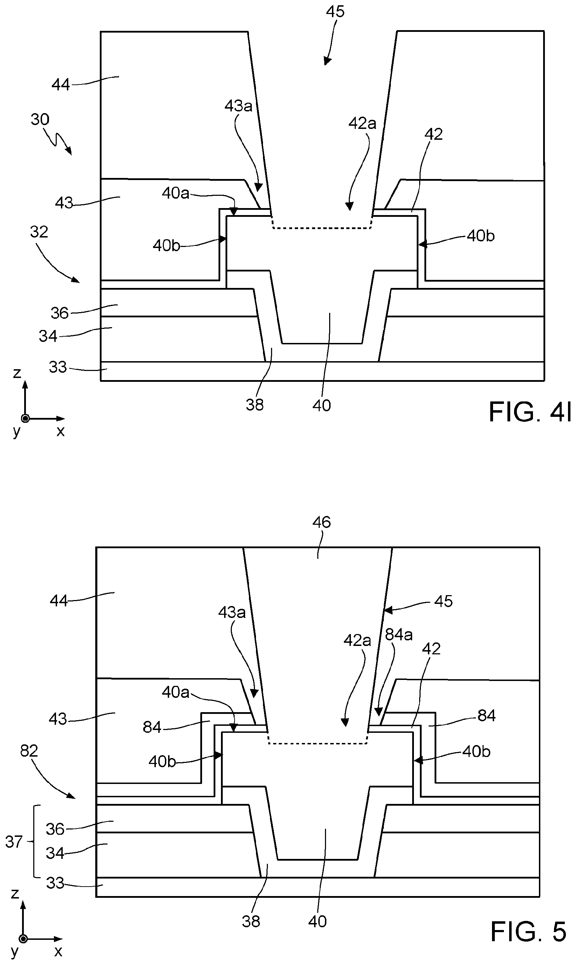

Then, Figure 4I, a packaging process is carried out, using a molding material (molding layer 44). The molding layer 44 is formed (e.g., deposited) above the insulating layer 43 and the coating layer 42, then opened through e.g., a Laser drilling. It is noted that the molding layer has a portion directly (physically) coupled to the insulating layer 43 and another portion directly (physically) coupled to the coating layer 42. Other embodiments are possible, where one or more intermediate layers between the insulating layer 43 and the molding layer 44, and/or between the coating layer 42 and the molding layer 44, are present.

The present description focuses only on the steps which are of interest for the understanding of the present invention (deposition of the molding on the wafer, Laser drilling at the pad to locally open the molding, then the Cu growth by electroplating).

The steps for forming the molding layer 44 are carried out during the back-end process, and it is known as such.

Selective portions of the molding layer 44 are then removed (for example by a LiSI - "Laser Induced Strip Interconnect" - process step), thereby forming the passing hole 45.

A step of forming a conductive connection region 46 (analogous to the pillar 25 of Figure 1) is then carried out. If the conductive region 40 is of metal (such as Copper), the conductive connection region 46 can be formed by electroplating metal (Copper) material, filling the apertures 42a, 43a and the passing hole 45 with such metal (Copper). The conductive connection region 46 thus formed is in electrical contact with the conductive region 40 and, through the conductive region 40, with the interconnection layer 33. The integrated circuit 30 of Figure 3 is thus formed.

The described process is one of the possible alternatives to form Copper interconnects. Alternatives may foresee the use of materials different from the molding for packaging, and techniques different for LiSI, such as an aEASI process.

Figure 5 shows a further embodiment of a redistribution layer 82 of present invention, where features/elements common to those of Figure 3 are identified using the same reference numerals and not further described.

The redistribution layer 82 differs from the redistribution layer 32 in that the redistribution layer 82 further comprises a second coating layer 84 that covers the coating layer 42 and the passivation layer 36, already described. The second coating layer 84 extends around the coating layer 42, i.e. at lateral walls (or sidewalls) and at least partially above the coating layer 42. The second coating layer 84 has an opening 84a which matches, in terms of shape and dimension, the opening 42a of the coating layer 42, or that is larger than the opening 42, so that, in top plan-view, the opening 42a is completely contained within the opening 84a. It is stressed that, as shown in Figure 4I, the opening 42 is formed during the Laser drilling process, during the same step used to form the aperture 45.

The second coating region 84 is made of a material having a low thermal expansion coefficient in the range 0.5.10⁻⁶ - 6.0.10⁻⁶ 1/K, to provide an further protection to the conductive region 40 during high-temperature EWS testing. In particular, the second coating region 84 provides a further protection against corrosion / oxidation / degradation of the conductive region 40 in case, during high-temperatures EWS processes, the coating region 42 locally breaks or cracks, which may happen for very thin coating regions 42.

Exemplary materials that can be used for the second coating layer 84 are insulators or dielectrics, such as Silicon Nitrides (e.g., Si₃N₄), Silicon Carbon Nitrides (SiCN), Silicon Oxides (e.g., SiO₂), Silicon Oxycarbides (SiOC). The second coating layer 84 can also be formed as a stack including one or more of the above-listed materials.

The second coating layer 84 has a thickness in the range 0.01 µm - 1 µm (for example, between 0.1 µm and 1 pm).

In general, the second coating region is chosen such that it can sustain high temperatures (up to 300°C) during high-temperature testing (such as EWS tests) without damages. In particular, such damages include cracking, fractures, etc., which may cause electromigration phenomena, electrochemical migrations, etc.

The process for manufacturing the redistribution layer 82 substantially conform with that already described for the redistribution layer 32, with the further steps of forming the second coating region 84 and etching the second coating region 84 to expose the underlying top surface of the coating region 42, prior to EWS test.

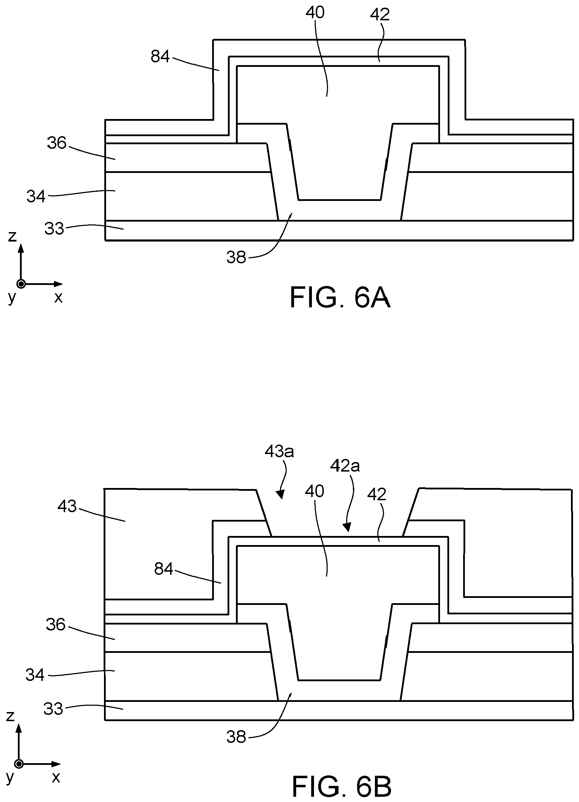

In particular, after the steps of Figures 4A-4G described above, a step shown in Figure 6A of depositing the second coating layer 84 is carried out, for example depositing by a CVD technique a dielectric material. In one embodiment, the second coating layer 84 is formed by PECVD (Plasma Enhanced Chemical Vapor Deposition). The second coating layer 84 completely covers the coating layer 42.

Then, after having carried out steps analogously to those described with reference to Figure 4H for forming the insulating layer 43 (whose aperture 43a exposes the second coating region 84), a step shown in Figure 6B of etching (e.g., by a dry etching process) the second coating region 84 is carried out. The etching of the second coating region 84 selectively removes the portions of the second coating region 84 exposed through the aperture 43a and stops at the coating region 42. Accordingly, the second coating region 84 and the coating region 42 are of respective materials that can be etched selectively to one another.

Then, with the surface of the coating region 42 exposed, EWS test can be conducted as already described.

The further steps described with reference to Figure 4I are carried out analogously.

It is noted that the presence of the second coating region 84 has the further advantage that the interface with the insulating layer 43 can be chosen of a material providing optimal adherence with the material of the insulating layer 43. Accordingly, the designer has more freedom to choose the material of the coating region 42, since the adherence of the latter with the insulating layer 43 is no more a design parameter.

The advantages of the invention described previously, according to the various embodiments, emerge clearly from the foregoing description.

In particular, the coating layer 42 is considerably thin and can be deposited by ALD with a highly controlled thickness, and good conformity. Is also provides a good diffusion barrier for the underlying Copper region 40 (it acts as a corrosion migration barrier); it further enables EWS testing without the need for a preliminary etching step, thus preserving the thermomechanical stability.

Further advantages include cost saving, due to a simpler manufacturing process than the prior art; no risk of undercut or lateral erosion of the conductive region 40 at the interface between the coating region 42 / conductive layer 40; improved oxidation protection during taping and reduced delamination in case of BSM (back side metal) needs; no risk of unstable EWS test at high temperatures; no risk of contamination of the conductive layer 40 during front-end (FE) processes and reduced contamination risk during EWS; low risk of corrosion when the device is stored in an uncontrolled environment before during / after EWS and shipment; low risk of corrosion of the conductive layer 40 during back grinding (tape contamination) and around pad opening (during LiSI or, generally, during direct Cu interconnect assembly). The embodiment of Figure 5 provides, further to the above-listed advantages, further advantages of improved protection, thanks to the double coating layers.

It is clear that modifications and variations may be made to what has been described and illustrated herein, without thereby departing from the scope of the present invention, as defined in the annexed claims.

In particular, even though the advantages and specific application of the present invention has been discussed with explicit reference to EWS testing, the present invention is advantageous, and can be used, to protect the conductive layer 40 from corrosion/oxidation phenomena during all phases of the FE (front-end) and BE (back-end) process flow (and between FE and BE), guaranteeing at the same time the electrical testability without degradation or pad probe instability (in particular during EWS/PT carried out between FE and BE phases).

To sum up the above detailed description, the present invention relates to:
A method of manufacturing a redistribution layer (32) for an integrated circuit (30), comprising the steps of:
- forming, on a conductive interconnection layer (33) of a wafer (60), a first insulating layer (37);
- forming a first opening (67) throughout the first insulating layer (37), up to reaching the conductive interconnection layer (33);
- forming a conductive body (40; 40, 38; 41) within said first opening (67), in electrical contract with said interconnection layer (33); and
- covering said conductive body (40; 40, 38; 41) with a first coating layer (42) having a thickness lower than 100 nm and configured to provide a protection against oxidation and/or corrosion of said conductive body (40; 40, 38).

Detailed embodiment are summarized hereunder:
In said method, the conductive interconnection layer (33) is a last metal line in a Back End Of Line, BEOL, manufacturing phase.

In said method, the first insulating layer (37) is formed on a completed integrated circuit (30).

Said method further comprising the steps of:
completely forming an integrated circuit (30) in the wafer (60); and
forming said first insulating layer (37) on the integrated circuit (30).

In said method, the step of forming the first coating layer (42) comprises forming a dielectric or insulating layer, in particular of a material including Aluminum and / or Hafnium.

In said method, the step of forming the first coating layer (42) comprises performing one among: a thermal atomic layer deposition, a plasma-assisted atomic layer deposition, a PECVD.

Said method comprising the steps of:
forming one or more second insulating layers (43, 44) around and partially above the first coating layer (42);
forming respective one or more second openings (43a, 45) throughout the one or more second insulating layers (43, 44), until a surface portion of the first coating layer (42) is exposed;
forming a third opening (42a) throughout the first coating layer (42), until a respective surface portion of the conductive body (40) is exposed;
forming a conductive pillar (46) within said one or more second openings (43a, 45) and said third opening (42a), in electrical contact with the conductive body (40).

In said method, forming one or more second insulating layers (43, 44) includes:
forming a photosensitive insulating layer (43) around and partially above the first coating layer (42);
forming a molding layer (44) on the photosensitive insulating layer (43); and
forming said second openings (43a, 45) throughout the photosensitive insulating layer (43) and the molding layer (44) .

Said method further comprising the step of completely covering the first coating layer (42) with a second coating layer (84) configured to sustain temperatures up to 300 °C without damages.

In said method the second coating layer (84) has a coefficient of thermal expansion in the range 0.5-10⁻⁶-6.0-10⁻⁶ 1/K.

In said method the second coating layer (84) is of a dielectric or insulating material such as a Silicon Nitride, a Silicon Carbon Nitride, a Silicon Oxycarbide, a Silicon Oxide.

In said method the second coating layer (84) has a thickness in the range 0.01 µm - 1 µm.

In said method the step of forming one or more second insulating layers (43, 44) includes forming said one or more second insulating layers (43, 44) on, and in direct contact with, said second coating layer (84).

In said method the step of forming the photosensitive insulating layer (43) includes forming the photosensitive insulating layer (43) on and in direct contact with said second coating layer (84).

In said method said photosensitive insulating layer (43) is of a material among: polyimide, PBO, Epoxy, photosensitive organic material.

In said method the step of forming a conductive body (40; 40, 38; 41) includes depositing Copper material.

In said method forming the conductive pillar (46) includes electroplating Copper material.

Said method further comprising the step of locally perforating with a testing probe or testing tip the first coating layer (42) until the conductive body (40) is electrically contacted by said testing probe or testing tip, for carrying out an electrical test of the integrated circuit.

Said method further comprising, before the step of locally perforating the first coating layer (42), the step of removing selective portions of the second coating layer (84) above the location where said step of locally perforating is to be carried out.

The present invention, further to method, relates to:
A redistribution layer (32) for an integrated circuit (30), comprising:
- a conductive interconnection layer (33)
- a first insulating layer (37) on the conductive interconnection layer (33);
- a first opening (67) throughout the first insulating layer (37), that reaches the conductive interconnection layer (33);
- a conductive body (40; 40, 38) within said first opening (67), in electrical contract with said interconnection layer (33); and
- a first coating layer (42) that covers said conductive body (40; 40, 38), has a thickness lower than 100 nm and is configured to provide a protection against oxidation and/or corrosion of said conductive body (40; 40, 38).

Detailed embodiment are summarized hereunder:
In said redistribution layer, the conductive interconnection layer (33) is a last metal line in a Back End Of Line, BEOL, manufacturing phase.

In said redistribution layer, the first insulating layer (37) extends on a completed integrated circuit (30).

In said redistribution layer, the first coating layer (42) comprises a dielectric or insulating material, in particular including Aluminum and / or Hafnium.

Said redistribution layer further comprising one or more second insulating layers (43, 44) around and partially above the first coating layer (42);
respective one or more second openings (43a, 45) throughout the one or more second insulating layers (43, 44), that reach a surface portion of the first coating layer (42) is exposed;
a third opening (42a) throughout the first coating layer (42), that reaches a respective surface portion of the conductive body (40);
a conductive pillar (46) within said one or more second openings (43a, 45) and said third opening (42a), in electrical contact with the conductive body (40).

In said redistribution layer, said one or more second insulating layers (43, 44) include:
a photosensitive insulating layer (43) around and partially above the first coating layer (42); and
a molding layer (44) on the photosensitive insulating layer (43),
said second openings (43a, 45) extending throughout the photosensitive insulating layer (43) and the molding layer (44).

Said redistribution layer further comprising a second coating layer (84) at least partially covering the first coating layer (42) and configured to sustain temperatures up to 300 °C without damages.

In said redistribution layer, the one or more second insulating layers (43, 44) extends on, and in direct contact with, said second coating layer (84).

Further to the above, the present invention relates to an integrated circuit (30) including a redistribution layer (32) according to the above. In particular, in the integrated circuit, the redistribution layer (32) is a last metal layer of said integrated circuit.

The present invention further relates to a method of performing an electrical test of a redistribution layer according to the above, comprising the steps of:
pressing a test probe or test tip against the coating layer (42); and
locally perforating the coating layer (42) up to reaching the underlying conductive body (40; 41).

## Claims

1. A method of manufacturing a redistribution layer (32) for an integrated circuit (30), comprising the steps of:
- forming, on a conductive interconnection layer (33) of a wafer (60), a first insulating layer (37);
- forming a first opening (67) throughout the first insulating layer (37), up to reaching the conductive interconnection layer (33);
- forming a conductive body (40; 40, 38; 41) within said first opening (67), in electrical contract with said interconnection layer (33); and
- covering said conductive body (40; 40, 38; 41) with a first coating layer (42) having a thickness lower than 100 nm and configured to provide a protection against oxidation and/or corrosion of said conductive body (40; 40, 38).

2. The method of claim 1, wherein the conductive interconnection layer (33) is a last metal line in a Back End Of Line, BEOL, manufacturing phase.

3. The method of claim 1 or 2, wherein the first insulating layer (37) is formed on a completed integrated circuit (30).

4. The method of claim 1 or 2, further comprising the steps of:
completely forming an integrated circuit (30) in the wafer (60); and
forming said first insulating layer (37) on the integrated circuit (30).

5. The method of anyone of the preceding claims, wherein the step of forming the first coating layer (42) comprises forming a dielectric or insulating layer, in particular of a material including Aluminum and / or Hafnium.

6. The method of anyone of the preceding claims, further comprising the steps of:
forming one or more second insulating layers (43, 44) around and partially above the first coating layer (42);
forming respective one or more second openings (43a, 45) throughout the one or more second insulating layers (43, 44), until a surface portion of the first coating layer (42) is exposed;
forming a third opening (42a) throughout the first coating layer (42), until a respective surface portion of the conductive body (40) is exposed;
forming a conductive pillar (46) within said one or more second openings (43a, 45) and said third opening (42a), in electrical contact with the conductive body (40).

7. The method of claim 6, wherein forming one or more second insulating layers (43, 44) includes:
forming a photosensitive insulating layer (43) around and partially above the first coating layer (42);
forming a molding layer (44) on the photosensitive insulating layer (43); and
forming said second openings (43a, 45) throughout the photosensitive insulating layer (43) and the molding layer (44).

8. The method of anyone of the preceding claims, wherein the step of forming a conductive body (40; 40, 38; 41) includes depositing Copper material.

9. The method of claims 6 and 8, wherein forming the conductive pillar (46) includes electroplating Copper material.

10. The method of anyone of the preceding claims, further comprising the step of locally perforating with a testing probe or testing tip the first coating layer (42) until the conductive body (40) is electrically contacted by said testing probe or testing tip, for carrying out an electrical test of the integrated circuit.

11. A redistribution layer (32) for an integrated circuit (30), comprising:
- a conductive interconnection layer (33)
- a first insulating layer (37) on the conductive interconnection layer (33);
- a first opening (67) throughout the first insulating layer (37), that reaches the conductive interconnection layer (33);
- a conductive body (40; 40, 38) within said first opening (67), in electrical contract with said interconnection layer (33); and
- a first coating layer (42) that covers said conductive body (40; 40, 38), has a thickness lower than 100 nm and is configured to provide a protection against oxidation and/or corrosion of said conductive body (40; 40, 38).

12. The redistribution layer of claim 11, wherein the conductive interconnection layer (33) is a last metal line in a Back End Of Line, BEOL, manufacturing phase.

13. The redistribution layer of claim 11 or 12, wherein the first insulating layer (37) extends on a completed integrated circuit (30).

14. The redistribution layer of anyone of claims 11-13, further comprising one or more second insulating layers (43, 44) around and partially above the first coating layer (42);
respective one or more second openings (43a, 45) throughout the one or more second insulating layers (43, 44), that reach a surface portion of the first coating layer (42) is exposed;
a third opening (42a) throughout the first coating layer (42), that reaches a respective surface portion of the conductive body (40);
a conductive pillar (46) within said one or more second openings (43a, 45) and said third opening (42a), in electrical contact with the conductive body (40).

15. An integrated circuit (30) including a redistribution layer (32) according to any one of claims 11-14.
